# EUROPEAN PATENT APPLICATION

(11) **EP 4 343 872 A1**
(43) Date of publication of application: **27.03.2024**
(21) Application number: 22804330.3
(22) Date of filing: 11.03.2022
(51) Int. Cl.: H01L 51/44, H01L 51/46

(54) **SOLAR CELL AND SOLAR CELL MANUFACTURING METHOD**

(30) Priority: 21.05.2021 JP 2021086528
(71) Applicant: Panasonic Holdings Corporation, Osaka 571-8501 (JP)
(72) Inventor: KAWANO, Kenji, Kadoma-shi Osaka 571-0057 (JP); MATSUI, Taisuke, Kadoma-shi Osaka 571-0057 (JP)
(74) Representative: Grünecker Patent- und Rechtsanwälte PartG mbB
(86) International application number: PCT/JP2022/010956
(87) International publication number: WO 2022/244411

(57) **Abstract**

A solar cell 100 of the present disclosure includes a first electrode 2, a photoelectric conversion layer 3, an intermediate layer 4, a hole transport layer 5, and a second electrode 6 in this order. The second electrode 6 includes an oxide. The intermediate layer 4 includes at least one compound selected from the group consisting of an iodide and a bromide. The compound includes a monovalent organic cation. The photoelectric conversion layer 3 may include, for example, a perovskite compound.

## Description

### Technical Field

The present disclosure relates to a solar cell and a method for manufacturing a solar cell.

### Background Art

In recent years, as new solar cells to replace existing silicon-based solar cells, organic thin-film solar cells and perovskite solar cells are being researched and developed. The perovskite solar cells use perovskite-type crystals represented by ABX₃ (A is a monovalent cation, B is a divalent cation, and X is a monovalent anion) and similar structures thereof (hereinafter, referred to as "perovskite compounds") as photoelectric conversion materials. NPL 1 discloses a solar cell using a perovskite compound represented by CH₃NH₃PbI₃ (hereinafter, also referred to as "MAPbI₃") as the photoelectric conversion material of the perovskite solar cell, using TiO₂ as the electron transport material, and using Spiro-OMeTAD as the hole transport material. NPL 2 discloses a tandem structure in which a silicon solar cell and a perovskite solar cell are stacked for the purpose of further improving the photoelectric conversion efficiency. Furthermore, NPL 3 discloses a see-through perovskite solar cell for an integrated building material, as a new application.

### Citation List

### Non Patent Literature

NPL 1: "Sequential deposition as a route to high-performance perovskite-sensitized solar cells", Nature, vol. 499, pp. 316-319, 18 July 2013 [DOI:10.1038/nature12340]
NPL 2: "Monolithic perovskite/silicon-homojunction tandem solar cell with over 22% efficiency", Energy Environ. Sci., 2017, 10, 2472. [DOI: 10.1039/c7ee02288c]
NPL 3: "Comparing energy performance of different semi-transparent, building-integrated photovoltaic cells applied to "reference" buildings", Energy Procedia, 126 (201709) 219. [DOI: 10.1016/j.egypro.2017.08.143.]

### Summary of Invention

### Technical Problem

It is an object of the present disclosure to provide a solar cell including an electrode containing an oxide, in which the solar cell has a configuration suitable for suppressing a reduction in the photoelectric conversion characteristics.

### Solution to Problem

The solar cell of the present disclosure includes:
a first electrode; a photoelectric conversion layer; an intermediate layer; a hole transport layer; and a second electrode in this order, wherein
the second electrode includes an oxide,
the intermediate layer includes at least one compound selected from the group consisting of an iodide and a bromide, and
the compound includes a monovalent organic cation.

### Advantageous Effects of Invention

The present disclosure provides a solar cell including an electrode containing an oxide, in which the solar cell has a configuration suitable for suppressing a reduction in the photoelectric conversion characteristics.

### Brief Description of Drawings

[Fig. 1] Fig. 1 shows a cross-sectional view of a solar cell 100 according to an embodiment of the present disclosure.
[Fig. 2] Fig. 2 shows a cross-sectional view of a solar cell 200 according to an embodiment of the present disclosure.
[Fig. 3] Fig. 3 shows a cross-sectional view of a solar cell 300 according to an embodiment of the present disclosure.

### Description of Embodiments

### <Underlying knowledge forming basis of the present disclosure>

A perovskite solar cell can highly efficiently generate power at a thickness of several hundred nanometers due to the characteristic physical properties of a perovskite compound, i.e., a high optical absorption coefficient and a long diffusion length, as shown in a literature "Qingfeng Dong et al., Science, 2015, 347, 6225, 967-970". The perovskite solar cell is further characterized by using less materials compared to existing silicon solar cells, not requiring high temperature during the formation process, being able to be formed by coating, and so on. Consequently, the perovskite solar cell can be developed to a building integrated solar cell combined with a building or the like and to a see-through solar cell by being directly formed on glass (e.g., NPL 3).

In order to further increase the photoelectric conversion efficiency, stacking of a perovskite solar cell and a silicon solar cell, i.e., a tandem solar cell, is being considered (for example, NPL 2).

In order to put the configuration above into practice, for example, it is necessary to allow light to enter the perovskite solar cell from the metal electrode side, such as a gold electrode, which has been used as an electrode. Consequently, the perovskite solar cell is required to be a light-transmissive perovskite solar cell.

When a light-transmissive oxide is used as an electrode material instead of a metal, in NPL 2, it is proposed to provide molybdenum oxide or the like between a hole transport layer and an electrode by a vapor deposition method in order to reduce the damage on the solar cell during the formation of the electrode. Consequently, since the process for producing the solar cell is complicated, it is desired to form an oxide electrode directly on the hole transport layer. However, when an oxide electrode is directly formed on a hole transport layer, the power generation characteristics (i.e., photoelectric conversion characteristics) of the solar cell decrease.

In view of these findings, the present inventors have conducted extensive research and, as a result, have found a new structure of a solar cell that can suppress a reduction in the photoelectric conversion characteristics even when an electrode containing an oxide is formed directly on the hole transport layer.

The term "perovskite solar cell" that is used in the present specification means a solar cell including a perovskite compound as a photoelectric conversion material or light-absorbing material.

### <Embodiment of the present disclosure>

The solar cell according to an embodiment of the present disclosure includes a first electrode, a photoelectric conversion layer, an intermediate layer, a hole transport layer, and a second electrode in this order. The second electrode contains an oxide. The intermediate layer includes at least one compound selected from the group consisting of an iodide and a bromide. The compound includes a monovalent organic cation.

The solar cell according to the present embodiment includes the second electrode containing an oxide. In the solar cell according to the present embodiment, the intermediate layer including at least one compound selected from the group consisting of an iodide and a bromide is provided between the photoelectric conversion layer and the hole transport layer. According to this configuration, in the solar cell according to the present embodiment, the damage on the solar cell (e.g., damage on the hole transport layer) when the second electrode is formed is alleviated to suppress a reduction in the photoelectric conversion characteristics. That is, the solar cell according to the present embodiment is a solar cell including an electrode containing an oxide and has a configuration suitable for suppressing a reduction in the photoelectric conversion characteristics. It is inferred that the damage on the solar cell when the second electrode is formed is, for example, a reduction in the characteristics by the damage on the hole transport layer by plasma, for example, when the second electrode is formed by a sputtering method.

In the solar cell according to the present embodiment, the second electrode may be in contact with the hole transport layer. Since the solar cell according to the present embodiment includes the above-described intermediate layer, even if the second electrode containing an oxide is formed directly on the hole transport layer, a reduction in the photoelectric conversion characteristics can be suppressed.

The solar cell according to the present embodiment may further include a substrate.

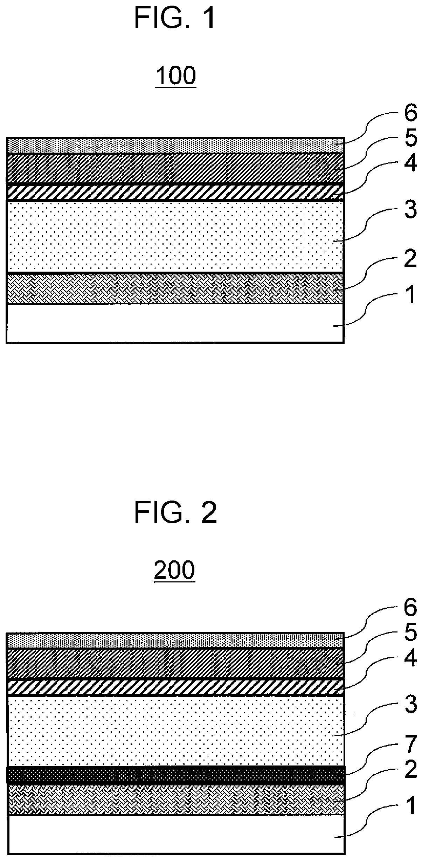

Fig. 1 shows a cross-sectional view of a solar cell 100 according to an embodiment of the present disclosure. The solar cell 100 has a first configuration example of the solar cell of the present disclosure.

As shown in Fig. 1, the solar cell 100 includes a substrate 1, a first electrode 2, a photoelectric conversion layer 3, an intermediate layer 4, a hole transport layer 5, and a second electrode 6 in this order.

The solar cell according to the present embodiment may further include an electron transport layer. The electron transport layer is disposed, for example, between the first electrode and the photoelectric conversion layer. Fig. 2 shows a cross-sectional view of a solar cell 200 according to an embodiment of the present disclosure. The solar cell 200 has a second configuration example of the solar cell of the present disclosure.

As shown in Fig. 2, the solar cell 200 includes a substrate 1, a first electrode 2, an electron transport layer 7, a photoelectric conversion layer 3, an intermediate layer 4, a hole transport layer 5, and a second electrode 6 in this order.

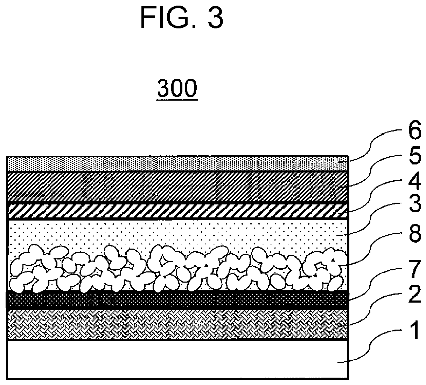

The solar cell according to the present embodiment may further include a porous layer. The porous layer is disposed, for example, between the electron transport layer and the photoelectric conversion layer. Fig. 3 shows a cross-sectional view of the solar cell 300 according to an embodiment of the present disclosure. The solar cell 300 has a third configuration example of the solar cell of the present disclosure.

As shown in Fig. 3, the solar cell 300 includes a substrate 1, a first electrode 2, an electron transport layer 7, a porous layer 8, a photoelectric conversion layer 3, an intermediate layer 4, a hole transport layer 5, and a second electrode 6 in this order.

The solar cell of the present embodiment may be manufactured by, for example, the following manufacturing method.

The manufacturing method according to the present embodiment includes, for example,
(A) forming an intermediate layer containing at least one selected from the group consisting of an iodide and a bromide,
(B) forming a hole transport layer containing a hole transport material, and
(C) forming an electrode containing an oxide by a sputtering method.

The electrode formed in the above (C) is, for example, the second electrode. In the above manufacturing method, although an electrode containing an oxide is formed by a sputtering method in the (C), the damage on the solar cell, in particular, on the hole transport layer by the sputtering method is alleviated by forming an intermediate layer containing at least one selected from the group consisting of an iodide and a bromide in the (A). Accordingly, a solar cell having photoelectric conversion characteristics suppressed from being reduced can be manufactured according to the manufacturing method above.

In the above (A), the intermediate layer may be formed by a coating method. According to such a method, a solar cell having photoelectric conversion characteristics suppressed from being reduced can be simply manufactured.

In the above (B), the hole transport layer may be formed by a coating method. According to such a method, a solar cell having photoelectric conversion characteristics suppressed from being reduced can be simply manufactured.

Here, taking a solar cell 300 of a third configuration example as an example, an example of its producing method will be described.

The solar cell 300 is produced by, for example, the following method.

First, a first electrode 2 is formed on a surface of a substrate 1 by chemical vapor deposition (CVD), a sputtering method, or the like. Subsequently, an electron transport layer 7 is formed on the first electrode 2 by, for example, a sputtering method. A porous layer 8 is formed on the electron transport layer 7 by, for example, a coating method. Then, a photoelectric conversion layer 3 is formed on the porous layer 8 by, for example, a coating method. Then, an intermediate layer 4 is formed on the photoelectric conversion layer 3 by, for example, a coating method. A hole transport layer 5 is formed on the intermediate layer 4 by, for example, a coating method. A second electrode 6 is formed on the hole transport layer 5 by, for example, a sputtering method. Thus, a solar cell 300 is obtained.

The solar cell 100 of the first configuration example according to the present embodiment can be produced by the same method as in the solar cell 300 except that the electron transport layer 7 and the porous layer 8 are not formed. The solar cell 200 of the second configuration example according to the present embodiment can be produced by the same method as in the solar cell 300 except that the porous layer 8 is not formed.

Each component of the solar cell of the present disclosure will now be described specifically.

### (Substrate 1)

The substrate 1 plays a role of retaining each layer of a solar cell. The substrate 1 can be formed from a transparent material. As such a material, a glass substrate or a plastic substrate can be used. The plastic substrate may be a plastic film.

When the first electrode 2 has sufficient strength, since the first electrode 2 can retain each layer, the substrate 1 need not be provided.

### (First electrode 2)

The first electrode 2 has conductivity.

The first electrode 2 may have light transmissivity. The first electrode 2 transmits, for example, light from the visible region to the near infrared region.

The first electrode 2 may be constituted of, for example, a metal oxide that is transparent and has conductivity. Examples of such a metal oxide are:
(i) an indium-tin composite oxide;
(ii) an indium-zinc composite oxide;
(iii) a tin oxide doped with antimony;
(iv) a tin oxide doped with fluorine;
(v) a zinc oxide doped with at least one element selected from the group consisting of boron, aluminum, gallium, and indium; and
(vi) composites thereof.

The first electrode 2 may be formed using a non-transparent material provided with a pattern for transmitting light. Examples of the pattern for transmitting light are line (e.g., stripe), wave line, and lattice (e.g., mesh) patterns and a punched metal pattern in which a large number of fine through-holes are arranged regularly or irregularly. When the first electrode 2 has such a pattern, light can transmit through the parts where the electrode material is not present. Examples of the non-transparent material are platinum, gold, silver, copper, aluminum, rhodium, indium, titanium, iron, nickel, tin, zinc, and alloys containing them. A carbon material having conductivity may be used as a non-transparent material.

When the solar cell does not include the electron transport layer 7, the first electrode 2 has a property of blocking holes from the photoelectric conversion layer 3. In this case, the first electrode 2 does not form an ohmic contact with the photoelectric conversion layer 3. Here, the property of blocking holes from the photoelectric conversion layer 3 is a property that allows only electrons generated in the photoelectric conversion layer 3 to pass through and not allows holes to pass through. The Fermi energy of a material having such a property is higher than the energy level of the upper end of the valence band of the photoelectric conversion layer 3. The Fermi energy of a material having such a property may be higher than that of the photoelectric conversion layer 3. Specific examples of the material include aluminum. Aluminum does not have light transmissivity. Accordingly, when a light transmissive electrode is formed using aluminum, for example, an electrode having a pattern shape as described above is adopted.

When the solar cell includes an electron transport layer 7 between the first electrode 2 and the photoelectric conversion layer 3, the first electrode 2 need not have a property of blocking holes from the photoelectric conversion layer 3. In this case, the first electrode 2 may be constituted of a material that can form an ohmic contact with the photoelectric conversion layer 3. In this case, the first electrode 2 may or may not form an ohmic contact with the photoelectric conversion layer 3.

The light transmittance of the first electrode 2 may be, for example, greater than or equal to 50% or greater than or equal to 80%. The wavelength of light that should pass through the first electrode 2 depends on the absorption wavelength of the photoelectric conversion layer 3. When the first electrode 2 is used in a cell on the light incident side of a tandem-type solar cell, for example, the transmittance of light of a wavelength of greater than or equal to 700 nm and 1100 nm may be greater than or equal to 50% or greater than or equal to 80% so that light outside the wavelength range to be absorbed by the photoelectric conversion layer 3 reaches the lower cell of the tandem-type solar cell provided on the lower side through the first electrode 2.

The first electrode 2 may have a thickness of, for example, greater than or equal to 1 nm and less than or equal to 1000 nm.

### (Electron transport layer 7)

The electron transport layer 7 includes a semiconductor. The electron transport layer 7 is desirably formed from a semiconductor with a band gap of greater than or equal to 3.0 eV. Consequently, it is possible to transmit visible light and infrared light to the photoelectric conversion layer 3. Examples of the semiconductor are an organic n-type semiconductor and an inorganic n-type semiconductor.

Examples of the organic n-type semiconductor are an imide compound, a quinone compound, a fullerene, and a fullerene derivative. Examples of the inorganic n-type semiconductor are a metal oxide and a perovskite oxide. Examples of the metal oxide are oxides of Cd, Zn, In, Pb, Mo, W, Sb, Bi, Cu, Hg, Ti, Ag, Mn, Fe, V, Sn, Zr, Sr, Ga, and Cr. The metal oxide is, for example, TiO₂ or SnO₂. The perovskite oxide is, for example, SrTiOs or CaTiO₃.

The electron transport layer 7 may include a material with a band gap of greater than 6 eV. Examples of the material with a band gap of greater than 6 eV are:
(i) a halide of an alkali metal or alkaline earth metal, such as lithium fluoride and calcium fluoride;
(ii) an oxide of an alkaline earth metal, such as magnesium oxide; and
(iii) silicon dioxide.

In this case, the electron transport layer 7 may have a thickness of, for example, less than or equal to 10 nm in order to secure an electron transport property.

The electron transport layer 7 may include multiple layers made of materials different from each other.

### (Porous layer 8)

The porous layer 8 is disposed, for example, between the photoelectric conversion layer 3 and the electron transport layer 7. The porous layer 8 can function as a base when the photoelectric conversion layer 3 is formed on the electron transport layer 7. The porous layer 8 does not impede light absorption of the photoelectric conversion layer 3 and electron transfer from the photoelectric conversion layer 3 to the electron transport layer 7.

The porous layer 8 includes a porous material. The porous material contains pores. The pores included in the porous layer 8 extend from the portion in contact with the electron transport layer 7 to the portion in contact with the photoelectric conversion layer 3.

The pores are typically filled with the material constituting the photoelectric conversion layer 3, and electrons can move directly from the photoelectric conversion layer 3 to the electron transport layer 7.

The porous material is formed by, for example, a chain of insulating or semiconducting particles. Examples of the insulating particles are aluminum oxide particles and silicon oxide particles. Examples of the semiconducting particles are inorganic semiconductor particles. Examples of the inorganic semiconductor are a metal oxide, a perovskite oxide of a metal element, a sulfide of a metal element, and a metal chalcogenide. Examples of the metal oxide are oxides of Cd, Zn, In, Pb, Mo, W, Sb, Bi, Cu, Hg, Ti, Ag, Mn, Fe, V, Sn, Zr, Sr, Ga, Si, and Cr. The metal oxide is, for example, TiO₂. Examples of the perovskite oxide of a metal element are SrTiO₃ and CaTiO₃. Examples of the sulfide of a metal element are CdS, ZnS, In₂S₃, PbS, Mo₂S, WS₂, Sb₂S₃, Bi₂S₃, ZnCdS₂, and CuS₂. Examples of the metal chalcogenide are CdSe, In₂Se₃, WSe₂, HgS, PbSe, and CdTe.

The thickness of the porous layer 8 may be greater than or equal to 0.01 µm and less than or equal to 10 µm or greater than or equal to 0.1 µm and less than or equal to 1 µm.

The porous layer 8 may have large surface roughness. Specifically, the surface roughness factor given by the value of (effective area)/(projected area) may be greater than or equal to 10 or greater than or equal to 100. The projected area is the area of the shadow formed behind an object when the object is illuminated with light from the front. The effective area is the actual surface area of the subject. The effective area can be calculated from the volume determined from the projected area and thickness of the subject and the specific surface area and bulk density of the material constituting the object.

### (Photoelectric conversion layer 3)

The photoelectric conversion layer 3 includes a photoelectric conversion material.

The photoelectric conversion material may be, for example, a perovskite compound. That is, the photoelectric conversion layer 3 may include a perovskite compound. Perovskite compounds have high optical absorption coefficient in the wavelength range of the sunlight spectrum and high carrier mobility. Accordingly, the solar cell including a perovskite compound (i.e., a perovskite solar cell) has a high photoelectric conversion efficiency.

The perovskite compound is represented by, for example, a compositional formula ABX₃, where A is a monovalent cation. Examples of the cation A is an alkali metal cation and an organic cation. Examples of the alkali metal cation are a methylammonium cation (CH₃NH₃⁺) and a formamidinium cation (NH₂CHNH₂⁺). An example of the organic cation is a cesium cation (Cs⁺). B is a divalent metal cation. Examples of the cation B are a Pb cation, a Sn cation, and a Ge cation. X is a monovalent anion. An example of the anion X is a halogen anion. The halogen anion is, for example, iodine and bromine. Each of the cation A, cation B, and anion X sites may be occupied by multiple types of ions.

The thickness of the photoelectric conversion layer 3 depends on the magnitude of light absorption but is, for example, greater than or equal to 100 nm and less than or equal to 2000 nm.

The photoelectric conversion layer 3 can be formed using a coating method or the like of a solution.

### (Intermediate layer 4)

The intermediate layer 4 includes at least one compound selected from the group consisting of a bromide and an iodide. The compound includes a monovalent organic cation.

The intermediate layer 4 functions as, for example, a layer for alleviating the damage occurring in the hole transport layer 5 when the second electrode 6 is formed.

The compound included in the intermediate layer 4 may include an ammonium cation. That is, the monovalent organic cation may be an ammonium cation.

The compound included in the intermediate layer 4 includes carbon and may have less than or equal to 8 carbon atoms. When the number of carbon atoms is less than or equal to 8, the hydrophobicity can be suppressed from increasing. Accordingly, the hole transport layer 5 that is formed thereon can be easily uniformly applied.

The compound included in the intermediate layer 4 includes carbon and may have greater than or equal to 4 and less than or equal to 8 carbon atoms. When the number of carbon atoms of the compound is greater than or equal to 4 and less than or equal to 8, the intermediate layer 4 can more alleviate the damage occurring, for example, in the hole transport layer 5 when the second electrode 6 is formed, and the hydrophobicity of the intermediate layer 4 can be suppressed from increasing.

The compound included in the intermediate layer 4 may be represented by, for example, the following formula (1):

R-NH₃X (1).

Here, in the formula (1),
R is a hydrocarbon group, and
X is at least one selected from the group consisting of iodine and bromine.

In the formula (1), R may be a hydrocarbon group having less than or equal to 8 carbon atoms. R may be a hydrocarbon group having greater than or equal to 4 and less than or equal to 8 carbon atoms.

In the formula (1), R may be an alkyl group, a phenyl group, or a phenylalkyl group.

The compound may be at least one selected from the group consisting of butylammonium bromide, hexylammonium bromide, octylammonium bromide, phenylethylammonium bromide, and phenylethylammonium iodide.

From the viewpoint of high affinity to each of a photoelectric conversion material (e.g., perovskite compound) and a hole transport material, the compound may be butylammonium bromide.

From the viewpoint of high heat-resistance, the compound may be phenylethylammonium iodide.

In order not to impede charge injection, the thickness of the intermediate layer 4 may be less than or equal to 10 nm.

### (Hole transport layer 5)

The hole transport layer 5 includes a hole transport material. The hole transport material is a material that transports holes.

The hole transport material may be a triphenylamine derivative.

Examples of the triphenylamine derivative are poly[bis(4-phenyl)(2,4,6-triphenylmethyl)amine] (hereinafter, referred to as "PTAA") and a PTAA derivative. In the PTAA derivative, at least a part of the hydrogen atoms and methyl groups of PTAA may be substituted by another functional group. For example, at least a part of the methyl groups of PTAA may be substituted by a hydrogen atom or a methoxy group. Alternatively, at least a part of the hydrogen atoms of PTAA may be substituted by a methyl group or a methoxy group.

The hole transport layer 5 may include not only the triphenylamine derivative but also another hole transport material. Examples of the hole transport material are an organic substance and an inorganic semiconductor.

Examples of the organic substance that is used as the hole transport material are poly(3-hexylthiophene-2, 5-diyl) (hereinafter, referred to as "P3HT") and poly(3, 4-ethylenedioxythiophene) (hereinafter, referred to as "PEDOT"). The molecular weight is not particularly limited, and the organic substance may be a macromolecule.

Examples of the inorganic semiconductor that is used as the hole transport material are Cu₂O, CuGaO₂, CuSCN, CuI, CuPC, NiOₓ₁, MoOₓ₂, V₂O₅, and a carbon-based material such as graphene oxide. Here, x1 is 0 < x1 and may be 1 ≤ x1 ≤ 1.5; and x2 is 0 < x2 and may be 2 ≤ x2 ≤ 3.

The hole transport layer 5 may include not only the hole transport layer material but also a fluoroboron-based compound. The fluoroboron-based compound is added as an additive for increasing the concentration of holes. Fluoroboron-based compounds have high stability and a redox potential suitable for oxidation of the hole transport material.

The fluoroboron-based compound is. for example, a boron compound having a pentafluorophenyl group. Examples of such a compound are tris(pentafluorophenyl)borane (TPFPB), 4-isopropyl-4'-methyldiphenyliodonium tetrakis(pentafluorophenyl)borate, and N,N-dimethylanilinium tetrakis(pentafluorophenyl)borate.

The fluoroboron-based compound may be TPFPB or a TPFPB derivative.

The hole transport layer 5 may include multiple layers made of materials different from each other.

The thickness of the hole transport layer 5 may be greater than or equal to 1 nm and less than or equal to 1000 nm or greater than or equal to 10 nm and less than or equal to 500 nm from the viewpoint of low resistance.

Examples of the method for forming the hole transport layer 5 are a coating method and a printing method. Examples of the coating method are a doctor blade method, a bar coating method, a spray method, a dip coating method, and a spin coating method. An example of the printing method is a screen printing method. The hole transport layer 5 may be formed by pressurizing or heat-treating a film obtained by mixing multiple materials. When the hole transport material is a low-molecular organic substance or an inorganic semiconductor, the hole transport layer 5 may be formed by a vapor deposition method.

The hole transport layer 5 may include a supporting electrolyte and a solvent. The supporting electrolyte and the solvent have an effect of stabilizing the holes in the hole transport layer 5.

Examples of the supporting electrolyte are an ammonium salt and an alkali metal salt. Examples of the ammonium salt are tetrabutylammonium perchlorate, tetraethylammonium hexafluorophosphate, an imidazolium salt, and a pyridinium salt. Examples of the alkali metal salt are lithium bis(trifluoromethanesulfony)imide (LiTFSI), LiN(SO₂CₙF₂ₙ₊₁)₂, LiPF₆, LiBF₄, lithium perchlorate, and potassium boron tetrafluoride.

The solvent included in the hole transport layer 5 may have high ion conductivity. The solvent may be either an aqueous solvent or an organic solvent. From the viewpoint of stabilization of the solute, the solvent may be an organic solvent. Examples of the organic solvent are heterocyclic compounds such as tert-butylpyridine (hereinafter, referred to as "tBP"), pyridine, and n-methylpyrrolidone.

As the solvent, an ionic liquid may be used alone or as a mixture with another solvent. Ionic liquids have low volatility and high flame retardance.

Examples of the ionic liquid are an imidazolium compound such as 1-ethyl-3-methylimidazolium tetracyanoborate, a pyridine compound, an alicyclic amine compound, an aliphatic amine compound, and an azonium amine compound.

### (Second electrode 6)

Since the solar cell of the present disclosure includes the hole transport layer 5, the second electrode 6 need not have a property of blocking electrons from the photoelectric conversion layer 3. That is, the material constituting the second electrode 6 may be a material forming an ohmic contact with the photoelectric conversion layer 3.

The second electrode 6 has conductivity and light transmissivity. The second electrode 6 includes an oxide. The second electrode 6 may be constituted of, for example, an oxide that is transparent and has conductivity. Examples of such an oxide are an indium-tin composite oxide, an indium-zinc composite oxide, and an indium-tungsten composite oxide. Thus, the second electrode 6 may include a conductive oxide of which the matrix is indium oxide. From the viewpoint of stability of the film characteristics, the second electrode 6 may include an indium-zinc composite oxide.

An example of the method for forming the second electrode 6 is a vapor growth method. Examples of the vapor growth method are a chemical vapor deposition (CVD) method and a sputtering method.

### EXAMPLES

The present disclosure will now be described in more detail with reference to Examples.

### <Example 1>

Components of the solar cell of Example 1 are respectively as follows:
Substrate: glass substrate (thickness: 0.7 mm);
First electrode: indium-tin composite oxide (indium-doped SnO₂ layer, surface resistance: 10 Ω/sq. manufactured by GEOMATEC Co., Ltd.);
Electron transport layer: TiO₂ (thickness: 20 nm, manufactured by GEOMATEC Co., Ltd.);
Porous layer: TiO₂;
Photoelectric conversion layer: a layer mainly containing a perovskite compound CH(NH₂)₂PbI₃ (thickness: about 500 nm);
Intermediate layer: butylammonium bromide (C₄H₉NH₃Br) (manufactured by Tokyo Chemical Industry Co., Ltd.);
Hole transport layer: PTAA (manufactured by Sigma-Aldrich Co. LLC) (however, including TPFPB (manufactured by Tokyo Chemical Industry Co., Ltd.) as an additive) (thickness: about 50 nm); and
Second electrode: indium-zinc composite oxide (IZO: 10wt% ZnO-doped In₂O₃) or indium-tin composite oxide (ITO: 10wt% SnO₂-doped In₂O₃) (thickness: 100 nm).

The solar cell of Example 1 was produced as below.

As a substrate, a first electrode, and an electron transport layer, a conductive glass substrate (manufactured by GEOMATEC Co., Ltd.) having a thickness of 0.7 mm and provided with an indium-tin composite oxide layer (indium-doped SnO₂ layer) and a TiO₂ layer was used. A solution obtained by diluting 150 mg of titanium oxide nanoparticle paste (NR-D30, manufactured by GreatCell Solar Limited) with 1 mL of ethanol was applied on the TiO₂ layer by spin coating and was then heat-treated at 500°C for 30 minutes. Thus, a porous layer was formed.

Subsequently, a solution containing PbI₂ (0.92 M, manufactured by Tokyo Chemical Industry Co., Ltd.), PbBr₂ (0.17 M, manufactured by Tokyo Chemical Industry Co., Ltd.), FAI (0.83 M, manufactured by GreatCell Solar Limited), MABr (0.17 M, manufactured by GreatCell Solar Limited), CsI (0.05 M, manufactured by Iwatani Corporation), and RbI (0.05 M, manufactured by Iwatani Corporation) was prepared. The solvent of the solution was a mixture of dimethyl sulfoxide (DMSO, manufactured by Acros Organics B.V.B.A.) and N,N-dimethylformamide (DMF, manufactured by Acros Organics B.V.B.A.). The mixing ratio of DMSO and DMF in the solution was 1 : 4 by volume. This solution was spin-coated on the porous layer and was annealed on a hot plate of 100°C for 45 minutes. Thus, a photoelectric conversion layer was formed.

Subsequently, 1 mL of an isopropanol (IPA) (manufactured by Acros Organics B.V.B.A.) solution containing 1 mg of butylammonium bromide (BABr) (manufactured by Tokyo Chemical Industry Co., Ltd.) was provided. This solution was spin-coated on the photoelectric conversion layer. Thus, an intermediate layer was formed.

Subsequently, 1 mL of a toluene (manufactured by Acros Organics B.V.B.A.) solution containing 10 mg of PTAA and 1.8 mg of TPFPB was provided. This solution was spin-coated on the intermediate layer. Thus, a hole transport layer was formed.

Finally, an IZO layer with a thickness of 100 nm was deposited using a 10%wt ZnO-doped In₂O₃ target on the hole transport layer by sputtering under conditions of back pressure: 2.8 × 10⁻⁴ Pa, substrate-target distance: 100 mm, substrate temperature: room temperature, power: 20 W, pressure: 1.0 Pa, and oxygen concentration: 0.4%. Thus, a second electrode was formed.

As in above, a solar cell of Example 1 was obtained. The above-described steps except for the step of forming the second electrode were carried out in a dry room under a dry atmosphere having a dew point of less than or equal to -40°C.

### <Example 2>

A solar cell of Example 2 was obtained as in Example 1 except that hexylammonium bromide (HABr) (C₆H₁₃NH₃Br) (manufactured by GreatCell Solar Limited) was used instead of BABr included in the solution for forming the intermediate layer.

### <Example 3>

A solar cell of Example 3 was obtained as in Example 1 except that octylammonium bromide (OABr) (C₈H₁₇NH₃Br) (manufactured by GreatCell Solar Limited) was used instead of BABr included in the solution for forming the intermediate layer.

### <Example 4>

A solar cell of Example 4 was obtained as in Example 1 except that phenylethylammonium bromide (PEABr) (C₈H₉NH₃Br) (manufactured by Tokyo Chemical Industry Co., Ltd.) was used instead of BABr included in the solution for forming the intermediate layer.

### <Example 5>

A solar cell of Example 5 was obtained as in Example 1 except that phenylethylammonium iodide (PEAI) (C₈H₉NH₃I) (manufactured by Tokyo Chemical Industry Co., Ltd.) was used instead of BABr included in the solution for forming the intermediate layer.

### <Comparative Example 1>

A solar cell of Comparative Example 1 was obtained as in Example 1 except that the intermediate layer was not formed.

### <Comparative Example 2>

A solar cell of Comparative Example 2 was obtained as in Example 1 except that phenylethylammonium iodide (PEAI) (C₈H₉NH₃I) (manufactured by Tokyo Chemical Industry Co., Ltd.) was used instead of BABr included in the solution for forming the intermediate layer and that the second electrode was formed by vacuum deposition of gold.

### <Comparative Example 3>

A solar cell of Comparative Example 3 was obtained as in Example 1 except that the intermediate layer was not formed and that the second electrode was formed by vacuum deposition of gold.

### <Example 6>

As a mixture solution for forming the hole transport layer, 1 mL of a toluene (manufactured by Acros Organics B.V.B.A.) solution containing 10 mg of PTAA, 6 µL of tBP, and 4.8 µL of an acetonitrile solution containing LiTFSI dissolved therein at a concentration of 1.8 M were mixed. A solar cell of Example 6 was obtained as in Example 1 except that the hole transport layer was formed by spin coating this mixture solution onto the intermediate layer.

### <Comparative Example 4>

A solar cell of Comparative Example 4 was obtained as in Example 6 except that the intermediate layer was not formed.

### <Example 7>

A solar cell of Example 7 was obtained as in Example 6 except that as the second electrode, ITO (10wt% SnO₂-doped In₂O₃) was used instead of IZO (10wt% ZnO-doped In₂O₃).

### <Example 8>

A solar cell of Example 8 was obtained as in Example 7 except that phenylethylammonium iodide (PEAI) (C₈H₉NH₃I) (manufactured by Tokyo Chemical Industry Co., Ltd.) was used instead of BABr included in the solution for forming the intermediate layer.

### <Comparative Example 5>

A solar cell of Comparative Example 5 was obtained as in Example 7 except that the intermediate layer was not formed.

### [Evaluation of solar cell characteristics]

The characteristics of the solar cells of Examples 1 to 8 and Comparative Examples 1 to 5 were evaluated under artificial sunlight by setting a solar simulator (ALS440B, manufactured by BAS Inc.) to an output of 100 mW/cm². The output current values against the applied voltage changing from 1.2 V to 0 V were recorded to calculate the conversion efficiency. Table 1 shows the initial efficiency of the solar cells of Examples 1 to 5 and Comparative Examples 1 to 3. Table 2 shows the initial efficiency of the solar cells of Example 6 and Comparative Example 4. Table 3 shows the initial efficiency of the solar cells of Examples 7 and 8 and Comparative Example 5.

### [Maintenance factor of photoelectric conversion efficiency]

The solar cells of Examples 1 to 5 and Comparative Example 1 were subjected to a heat run test.

The target solar cells were stored in a thermostat bath of 85°C for 100 hours and were taken out from the thermostat bath after 100 hours. Then, the solar simulator was set to an output of 100 mW/cm², and the solar cell characteristics were evaluated under artificial sunlight. The output current values against the applied voltage changing from 1.2 V to 0 V were recorded to calculate the conversion efficiency. The rate of change in the photoelectric conversion efficiency was calculated by [(photoelectric conversion efficiency at initial 0 hour) - (photoelectric conversion efficiency after storage at 85°C for 100 hours)]/(photoelectric conversion efficiency at initial 0 hour). Table 1 shows the maintenance factor of the photoelectric conversion efficiency of each of the solar cells of Examples 1 to 5 and Comparative Example 1.

**[Table 1]**

| | Intermediate layer (Number of carbon atoms of compound) | Second electrode | Conversion efficiency (%) | Maintain rate of conversion efficiency |
|---|---|---|---|---|
| Example 1 | BABr (4) | IZO | 17.1 | 1.004 |
| Example 2 | HABr (6) | IZO | 15.6 | 0.945 |
| Example 3 | OABr (8) | IZO | 15.8 | 0.982 |
| Example 4 | PEABr (8) | IZO | 15.2 | 0.964 |
| Example 5 | PEAI (8) | IZO | 15.4 | 1.009 |
| Comparative Example 1 | - | IZO | 14.5 | 0.913 |
| Comparative Example 2 | PEAI (8) | Au | 19.1 | - |
| Comparative Example 3 | - | Au | 19.7 | - |

**[Table 2]**

| | Intermediate layer (Number of carbon atoms of compound) | Second electrode | Conversion efficiency (%) |
|---|---|---|---|
| Example 6 | BABr (4) | IZO | 15.8 |
| Comparative Example 4 | - | IZO | 14.3 |

**[Table 3]**

| | Intermediate layer (Number of carbon atoms of compound) | Second electrode | Conversion efficiency (%) |
|---|---|---|---|
| Example 7 | BABr (4) | ITO | 11.0 |
| Example 8 | PEAI (8) | ITO | 10.9 |
| Comparative Example 5 | - | ITO | 10.7 |

### (Consideration)

As shown in Table 1, the solar cells of Examples 1 to 5 each including an intermediate layer containing at least one compound selected from the group consisting of an iodide and a bromide showed high conversion efficiency compared to the solar cell of Comparative Example 1 not including the intermediate layer 4.

As obvious by comparing Example 5 and Comparative Example 2 with Comparative Example 1 and Comparative Example 3, respectively, it was recognized that a large effect of improving the efficiency was exhibited by providing an intermediate layer when an oxide IZO was used as the second electrode.

Among Examples, when the intermediate layer contained BABr, high conversion efficiency was observed. High efficiency maintenance factor during the high-temperature storage was observed when the intermediate layer contained PEAI.

As shown in Table 2, as obvious by comparing Example 6 with Comparative Example 4, the same effect was observed also in a system in which the hole transport layer included a supporting electrolyte and a solvent.

As shown in Table 3, as obvious by comparing Examples 7 and 8 with Comparative Example 5, an effect of improving the efficiency by the intermediate layer was observed even when an oxide ITO was used as the second electrode.

### Industrial Applicability

The solar cell of the present disclosure can be used in various applications including the applications of existing solar cells.

### Reference Signs List

1 substrate
2 first electrode
3 photoelectric conversion layer
4 intermediate layer
5 hole transport layer
6 second electrode
7 electron transport layer
8 porous layer
100, 200, 300 solar cell

## Claims

1. A solar cell comprising a first electrode, a photoelectric conversion layer, an intermediate layer, a hole transport layer, and a second electrode in this order, wherein
the second electrode includes an oxide,
the intermediate layer includes at least one compound selected from the group consisting of an iodide and a bromide, and
the compound include a monovalent organic cation.

2. The solar cell according to claim 1, wherein
the photoelectric conversion layer includes a perovskite compound.

3. The solar cell according to claim 1 or 2, wherein
the monovalent organic cation includes an ammonium cation.

4. The solar cell according to any one of claims 1 to 3, wherein
the compound included in the intermediate layer includes carbon and has less than or equal to 8 carbon atoms.

5. The solar cell according to claim 4, wherein
the number of carbon atoms is greater than or equal to 4 and less than or equal to 8.

6. The solar cell according to any one of claims 1 to 5, wherein
the compound included in the intermediate layer is represented by a following formula (1):
R-NH₃X (1)
here, in the formula (1),
R is a hydrocarbon group, and
X is at least one selected from the group consisting of iodine and bromine.

7. The solar cell according to claim 6, wherein
in the formula (1), R is an alkyl group, a phenyl group, or a phenylalkyl group.

8. The solar cell according to any one of claims 1 to 7, wherein
the compound included in the intermediate layer is at least one selected from the group consisting of butylammonium bromide, hexylammonium bromide, octylammonium bromide, phenylethylammonium bromide, and phenylethylammonium iodide.

9. The solar cell according to claim 8, wherein
the compound included in the intermediate layer includes butylammonium bromide.

10. The solar cell according to claim 9, wherein
the compound included in the intermediate layer includes phenylethylammonium iodide.

11. The solar cell according to any one of claims 1 to 10, wherein
the oxide includes a conductive oxide of which a matrix is indium oxide.

12. The solar cell according to any one of claims 1 to 11, wherein
the oxide includes an indium-zinc composite oxide.

13. The solar cell according to any one of claims 1 to 12, wherein
the hole transport layer includes a hole transport material, and
the hole transport material includes poly[bis(4-phenyl)(2,4,6-triphenylmethyl)amine].

14. The solar cell according to any one of claims 1 to 13, wherein
the second electrode is in contact with the hole transport layer.

15. A method for manufacturing a solar cell, comprising:
(A) forming an intermediate layer including at least one selected from the group consisting of an iodide and a bromide;
(B) forming a hole transport layer including a hole transport material; and
(C) forming an electrode including an oxide by a sputtering method.

16. The manufacturing method according to claim 15, wherein
in the (B), the hole transport layer is formed by a coating method.

17. The manufacturing method according claim 15 or 16, wherein
in the (A), the intermediate layer is formed by a coating method.
